# EUROPEAN PATENT APPLICATION

(11) **EP 2 224 793 A1**
(43) Date of publication of application: **01.09.2010**
(21) Application number: 10151320.8
(22) Date of filing: 21.01.2010
(51) Int. Cl.: H05K 1/02, H05K 5/02, H05K 9/00

(54) **Circuit board and circuit board assembly**

(30) Priority: 26.02.2009 JP 2009043779
(71) Applicant: Alps Electric Co., Ltd., Tokyo 145-8501 (JP)
(72) Inventor: Matsubara, Satoshi, Tokyo Tokyo 145-8501 (JP)
(74) Representative: Klunker . Schmitt-Nilson . Hirsch

(57) **Abstract**

A circuit board (1) received in a casing (110) having a gap (112) includes a board main body (1a), a plurality of circuit patterns (10, 11, 12, 13) arranged on the principal surface of the board main body (1a) such that the patterns are isolated from each other, and angular parts (10A, 13A) that induce a discharge of static electricity, the angular parts being included in some patterns (10, 13) of the patterns (10, 11, 12, 13) such that the angular parts are arranged in an area (105) facing the gap (112) of the casing (110). In the circuit board (1), the circuit patterns (10, 13) with the angular parts (10A, 13A) are arranged so as to surround the other circuit patterns (11, 12). Each of the angular parts (10A, 13A) is shaped in a series of rectangles or triangles.

## Description

### BACKGROUND OF THE INVENTION

### 1. Field of the Invention

The present invention relates to a circuit board mounted on an electronic device or a component constituting an electronic device, and in particular, relates to a static-proof circuit board and circuit board assembly.

### 2. Description of the Related Art

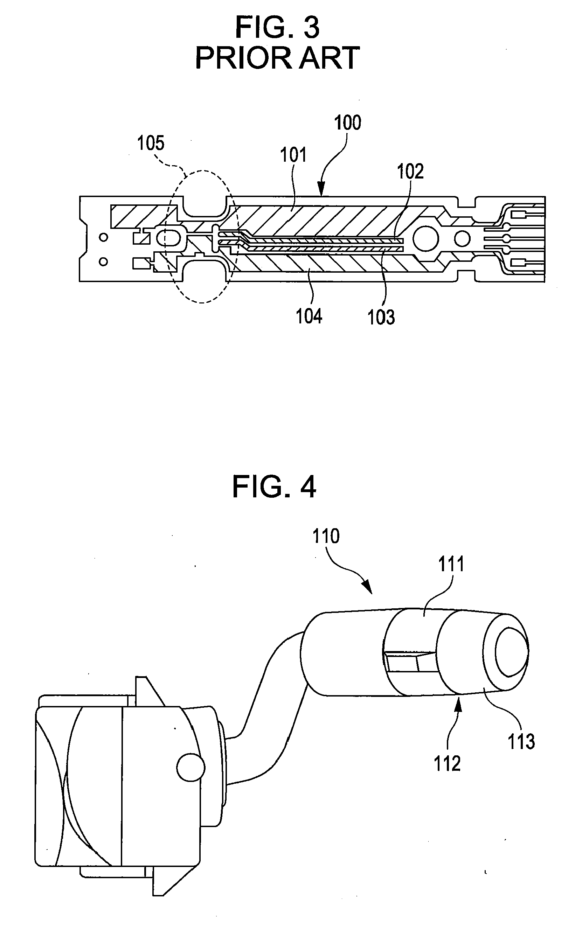

Hitherto, circuit boards mounted on electronic devices are made proof against static electricity in order to protect circuit components. When a discharge of static electricity occurs in the vicinity of a circuit board provided with a plurality of circuit patterns, it is difficult to specify through which circuit pattern discharge current flows to the ground. Accordingly, for making electronic components, such as an integrated circuit (IC), connected to the circuit patterns proof against static electricity, an antistatic component (i.e., a component that dissipates static electricity) is provided for each of the circuit patterns. Fig. 3 is a plan view of a circuit board 100 built in a wiper switch in a car. The circuit board 100 is provided with four kinds of circuit patterns 101 to 104. An antistatic component (not shown) is provided for each of these circuit patterns 101 to 104.

Discharges due to static electricity include a discharge of charge accumulated in or on a human body. For example, assuming that a person gets on a car in a dry season, charge is generated by the friction between clothes of the person and a sheet, so that the charge is accumulated on the clothes. For example, when a driver operates a slide switch for wiper time control disposed in a wiper lever, the charge (static electricity) accumulated on the clothes of the driver may be discharged through a slight gap in the slide switch to a circuit pattern in a circuit board (refer to Fig. 3) received in the wiper lever.

Fig. 4 is a perspective view illustrating a wiper lever in a car. Referring to Fig. 4, a slide switch 111 for wiper time control is disposed in an end portion of a wiper lever 110. Charge accumulated on clothes of a driver flows through any gap between a main body of the lever 110 and the slide switch 111, i.e., a gap adjacent to the proximal end of the wiper lever 110 or a gap 112 adjacent to the distal end thereof, thus causing a discharge of the charge in a circuit board built in the wiper lever 110. In this case, an area 105 surrounded by a dashed line in the circuit board 100 shown in Fig. 3 corresponds to the position of the slide switch 111 in the wiper lever 110. This area serves as an entrance which static electricity enters through the gap 112 between the lever main body and the slide switch 111. The static electricity entered the static-electricity entrance of the circuit board 100 flows through any of the circuit patterns 101 to 104 and is then removed by the antistatic component provided for the circuit pattern which has undergone the discharge.

Related arts are disclosed in Japanese Unexamined Utility Model Registration Application Publication No. 5-076071 and Japanese Unexamined Patent Application Publication No. 9-045194 and No. 2004-134453.

### SUMMARY OF THE INVENTION

However, providing the antistatic components for all of the circuit patterns arranged in the circuit board results in an increase in the number of components. Disadvantageously, this leads to increased costs. For example, since the circuit board 100 shown in Fig. 3 has the four kinds of circuit patterns 101 to 104, at least four antistatic components are needed.

The present invention has been made in consideration of the above-described disadvantages. The present invention provides a circuit board and circuit board assembly which are capable of reliably protecting electronic components, such as an IC, connected to circuit patterns from static electricity while achieving a reduction in the number of antistatic components used.

An aspect of the present invention provides a circuit board received in a casing having a gap, the circuit board including a board main body, a plurality of patterns arranged on the principal surface of the board main body such that the patterns are isolated from each other, and angular parts that induce a discharge of static electricity, the angular parts being included in some of the patterns such that the angular parts are arranged in an area facing the gap in the casing.

With this structure, the angular parts that induce a discharge of static electricity are included in some of the patterns arranged in the circuit board, thus remarkably reducing a probability that static electricity flows into the other patterns. Accordingly, antistatic components can be omitted from the other patterns. Consequently, a reduction in the number of antistatic components can be achieved, thus reducing costs.

In the circuit board, the patterns with the angular parts may be arranged so as to surround the patterns with no angular parts. Since the patterns which are made proof against static electricity (or in which measures to prevent instantaneous overcurrent are taken) surround the other patterns, the patterns made proof against static electricity function as protective patterns, thus improving the resistance of the other patterns to external electrical noise including static electricity.

In the circuit board, each of the angular parts may be shaped in a series of rectangles or triangles.

Another aspect of the present invention provides a circuit board assembly received in a casing having a gap, the circuit board assembly including a board main body and a plurality of patterns arranged on the principal surface of the board main body such that the patterns are isolated from each other. The patterns include angled patterns with angular parts that induce a discharge of static electricity and non-angled patterns with no angular parts, the angular parts being included in the angled patterns such that the angular parts are arranged in an area facing the gap in the casing. The angled patterns are arranged so as to surround the non-angled patterns. Only the angled patterns are made proof against static electricity.

With this structure, only the patterns with the angular parts are made proof against static electricity, thus reducing costs.

The circuit board and the circuit board assembly according to the aspects of the present invention can reliably protect electronic components, such as an IC, connected to the circuit patterns from static electricity while achieving a reduction in the number of antistatic components used.

### BRIEF DESCRIPTION OF THE DRAWINGS

Fig. 1 is a plan view of a circuit board according to an embodiment of the present invention;
Fig. 2 is a diagram illustrating the circuit board of Fig. 1 built in a wiper lever.
Fig. 3 is a plan view of a conventional circuit board; and
Fig. 4 is a perspective view of a wiper lever in a car.

### DESCRIPTION OF THE PREFERRED EMBODIMENTS

An embodiment of the present invention will be described in detail below with reference to the accompanying drawings.

A circuit board according to an embodiment of the present invention is built in a casing which serves as a housing of a wiper lever in a car in a manner similar to the circuit board 100 shown in Fig. 3.

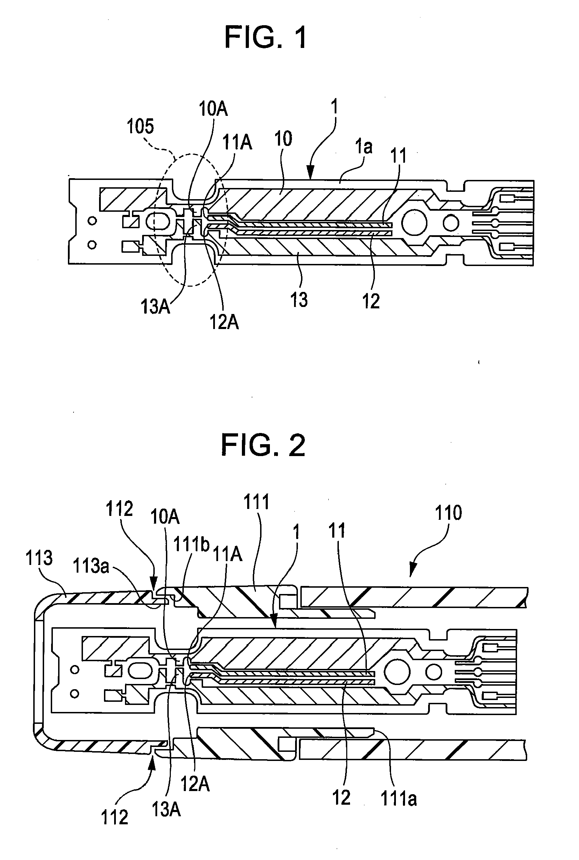

Fig. 1 is a plan view of the circuit board according to the embodiment of the present invention. Fig. 2 is a plan view of the circuit board built in a wiper lever partially cut away. Referring to Fig. 2, a casing 110 which serves as an external wall of the wiper lever is illustrated in cross-sectional view and the circuit board 1 is illustrated in plan view.

Referring to Fig. 1, the circuit board, indicated at 1, has four kinds of circuit patterns 10 to 13 formed on at least one surface (principal surface) of a main body (hereinafter, referred to as a "board main body") 1a of the circuit board such that the circuit patterns 10 to 13 are isolated from each other. An electronic component (not shown) is mounted on each of the circuit patterns 10 to 13. In the arrangement of the patterns in Fig. 1, the two circuit patterns 10 and 13 are arranged so as to surround the two circuit patterns 11 and 12 extending between the patterns 10 and 13. In other words, the circuit patterns 11 and 12 extend in the middle of the board and the circuit patterns 10 and 13 are arranged so as to be closer to sides of the board than the circuit patterns 11 and 12. To protect electronic components, such as an IC, connected to the circuit patterns 10 and 13, from static electricity, antistatic components (not shown) are provided for the circuit patterns 10 and 13, respectively.

The circuit patterns 10 and 13 include angular parts 10A and 13A each shaped in a series of rectangles, respectively. The angular parts 10A and 13A are positioned in an area 105, surrounded by a dashed line in Fig. 1, corresponding to a static electricity entrance. The other circuit patterns 11 and 12 include semicircular end parts 11A and 12A which serve as non-angular parts, respectively. The semicircular parts 11A and 12A are positioned in the area 105, indicated by the dashed line in Fig. 1, corresponding to the static electricity entrance.

Referring to Fig. 2, the slide switch 111 is rotatably attached to one end of the wiper lever casing 110. The slide switch 111 includes a connecting portion 111a inserted in an opening in the end of the wiper lever casing 110. The connecting portion 111a has an outer diameter slightly smaller than the inner diameter of the wiper lever casing 110. The connecting portion 111a is sized so as to be inserted from the opening of the end portion of the wiper lever casing 110 into the casing 110 as far as it will go. Accordingly, the overlap between the external wall of the wiper lever casing 110 and the connecting portion 111a is long to provide a structure that makes the entrance of static electricity through a gap between the external wall of the wiper lever casing 110 and the connecting portion 111a difficult. When the connecting portion 111a of the slide switch 111 is permitted to be long, a structure that prevents the entrance of static electricity can be provided.

On the other hand, a rotary operating member 113 is rotatably attached to one end of the slide switch 111. The rotary operating member 113 includes a connecting portion 113a rotatably attached to a stepped portion 111b formed on the inner wall of the open end of the slide switch 111. The overlap between the stepped portion 111b and the connecting portion 113a is restricted to a slight extent for lack of space. A gap 112 is provided between the stepped portion 111b and the connecting portion 113a. Since the rotary operating member 113 is a component directly touched by a driver, the gap 112 positioned in the vicinity of the rotary operating member 113 serves as a static electricity entrance as viewed from the circuit board 1. A casing constituting the external wall of the slide switch 111 (including the rotary operating member 113) directly touched by the driver typically includes a plastic molding made of a nonmetal material. When the driver touches the rotary operating member 113, therefore, static electricity entered through the gap 112 into the casing may be discharged in the circuit patterns. Accordingly, the area 105 indicated by the dashed line of Fig. 1 corresponds to the static electricity entrance.

As described above, in the present embodiment, an antistatic component is provided for each of the circuit patterns 10 and 13. In addition, the angular parts 10A and 13A for causing a discharge of static electricity are provided for the circuit patterns 10 and 13, respectively. Parts of the other circuit patterns 11 and 12 in the vicinity of the static electricity entrance are formed as non-angular parts (the semicircular end parts 11A and 12A). Consequently, there is a predominant probability that static electricity entered through the static electricity entrance shown by the dashed line flows toward the angular parts 10A and 13A of the circuit patterns 10 and 13, while the non-angular parts of the other circuit patterns 11 and 12 are also positioned in the vicinity of the static electricity entrance.

The other circuit patterns 11 and 12 arranged in the vicinity of the static electricity entrance include no angular part. Accordingly, the non-angular parts of the circuit patterns 11 and 12 and the angular parts 10A and 13A of the circuit patterns 10 and 13 are arranged in the vicinity of the static electricity entrance. Since the circuit patterns 11 and 12 are intentionally formed so as not to have a shape causing a discharge of static electricity, the circuit patterns 11 and 12 each have a low probability that static electricity entered through the static electricity entrance is discharged to flow into the circuit pattern. It is therefore unnecessary to provide an antistatic component (not shown) that protects an electronic component, such as an IC, connected to a circuit pattern from static electricity for each of the circuit patterns 11 and 12.

Furthermore, since the circuit patterns 11 and 12 are surrounded by the circuit patterns 10 and 13 which are made proof against static electricity (or in which measures to prevent instantaneous overcurrent are taken), the circuit patterns 10 and 13 function as protective patterns, thus improving the resistance of the circuit patterns 11 and 12 to external electrical noise including static electricity.

Irrespective of whether the circuit patterns 11 and 12 having no angular parts are arranged inside the circuit patterns 10 and 13 having the angular parts 10A and 13A, static electricity can be allowed to flow into the circuit patterns 10 and 13 having the angular parts 10A and 13A.

As described above, according to the present embodiment, some of the circuit patterns 10 to 13 arranged in the circuit board 1, namely, the circuit patterns 10 and 13 have the angular parts 10A and 13A that induce a discharge of static electricity, thereby remarkably reducing a probability that static electricity flows into the other circuit patterns 11 and 12. Thus, antistatic components can be omitted from the circuit patterns 11 and 12. Advantageously, the number of antistatic components used can be reduced, thus reducing costs.

The above description relates to the embodiment in which the circuit board 1 according to the embodiment of the present invention is applied to the wiper lever in the car. In addition to the wiper lever in the car, the present invention can be similarly applied to other electronic devices having a structure in which a circuit board is built in a casing and static electricity may enter through a gap in the casing. Furthermore, in addition to a circuit board assembly incorporated in the wiper lever in the car, the present invention can be applied to other circuit board assemblies including a circuit board and electrical components mounted on the board. In each circuit board assembly, only a pattern having an angular part is made proof against static electricity, thus reducing costs.

In the above-described embodiment, each of the angular parts 10A and 13A of the circuit patterns 10 and 13 is shaped in a series of rectangles, as shown in Fig. 1. The shape of such a circuit pattern is not limited to the above shape. So long as each angular part easily induces a discharge of static electricity, the angular part may have any shape. For example, when each angular part is sawtoothed such that the part is shaped in a series of triangles, similar functions can be achieved.

The present invention is applicable to a static electricity measure for a circuit board mounted on an electronic device.

## Claims

1. A circuit board (1) received in a casing (110) having a gap (112), comprising:
a board main body (1a);
a plurality of patterns (10, 11, 12, 13) arranged on the principal surface of the board main body (1a) such that the patterns are isolated from each other; and
angular parts (10A, 13A) that induce a discharge of static electricity, the angular parts being included in some patterns (10, 13) of the patterns (10, 11, 12, 13) such that the angular parts are arranged in an area (105) facing the gap (112) in the casing (110).

2. The circuit board according to Claim 1, wherein the patterns (10, 13) with the angular parts (10A, 13A) are arranged so as to surround the patterns (11, 12) with no angular parts.

3. The circuit board according to Claim 1 or 2, wherein each of the angular parts (10A, 13A) is shaped in a series of rectangles or triangles.

4. A circuit board assembly received in, a casing (110) having a gap (112), comprising:
a board main body (1a); and
a plurality of patterns (10, 11, 12, 13) arranged on the principal surface of the board main body (1a) such that the patterns are isolated from each other, wherein
the patterns (10, 11, 12, 13) include angled patterns (10, 13) with angular parts (10A, 13A) that induce a discharge of static electricity and non-angled patterns (11, 12) with no angular parts, the angular parts being included in the angled patterns such that the angular parts are arranged in an area (105) facing the gap (112) in the casing (110),
the angled patterns (10, 13) are arranged so as to surround the non-angled patterns (11, 12), and
only the angled patterns (10, 13) are made proof against static electricity.
